# EUROPEAN PATENT APPLICATION

(11) **EP 4 826 914 A1**
(43) Date of publication of application: **21.10.2026**
(21) Application number: 26172760.6
(22) Date of filing: 16.04.2026
(51) Int. Cl.: H01R 9/05, H01B 7/08, H01B 11/18, H01P 3/06, H01B 11/10

(54) **THE SHIELDED WIRE WITH AN INTEGRATED BONDING CONDUCTOR**

(30) Priority: 16.04.2025 US 202519181128
(71) Applicant: Pratt & Whitney Canada Corp., Longueuil, Québec J4G 1A1 (CA)
(72) Inventor: PROKOFYEV, Sergey, (01BE5) Longueuil, J4G 1A1 (CA); BRANDT, Richard, (01BE5) Longueuil, J4G 1A1 (CA)
(74) Representative: Dehns

(57) **Abstract**

An apparatus for protecting signals from electromagnetic interference comprising a first conducting wire (302) configured to carry the signals from a first end of the first conducting wire (302) to a second end of the first conducting wire (302). A shield (306) made of a conducting material surrounds the first conducting wire (302) from the first end of the first conducting wire (302) to the second end of the first conducting wire (302). A second conducting wire (300) is associated with the shield (306). A ground connection connects the second conducting wire (300) to ground at a single location.

## Description

### TECHNICAL FIELD

This invention relates generally to shielding of wires from electromagnetic interference. More specifically, this invention relates to a shielded wire having an integrated bonding conductor to shield from electromagnetic interference.

### BACKGROUND

The engine control system within an aircraft engine contains electrical wires carrying very low voltage signals. These low voltage signals can come from components such as thermocouples, speed probes, vibration sensors, etc. The low voltage signals must be protected from interference from things such as ignition cables, generator power cables, PMA power, lighting, etc. These types of wires are usually shielded and the shielding is grounded (or terminated) at both ends of the cable. The shield is able to protect the signal wire only between the shield bonding points. Usually, the bonding points are provided by the termination of the shields on the backshells. However, for individual wires connected to terminal lugs, the bonding is performed by metallic clamps at each end of the cable. As clamping locations are limited, the length of the EMI (electromagnetic interference) protection cannot be optimized as it is a function of the clamp interfaces. Additionally, for short cables with multiple daisy chained connections (typical of thermocouple installations), additional clamps are required. This requires more cost and weight to support the engine harness cable, and makes wires installation more complicated. Thus, an improved manner for providing shielding for a wire would be greatly beneficial.

### SUMMARY

This invention relates to shielding of wires from electromagnetic interference.

According to an aspect of the present invention, an apparatus for protecting signals from electromagnetic interference includes a first conducting wire, configured to carry the signals from a first end of the first conducting wire to a second end of the first conducting wire, a shield made of a conducting material surrounding the first conducting wire from the first end of the first conducting wire to the second end of the first conducting wire, a second conducting wire associated with the shield, and a ground connection configured to connect the second conducting wire or shied to ground at a single location.

Optionally, and in accordance with the above, an electrical circuit created by connection between the second conducting wire and the shield generates an electric current responsive to an external electric field in a first direction, the electric current generating an internal electric field in a second direction, wherein the internal electric field substantially eliminates effects of the external electric field to protect the signals on the first conducting wire from interference by the external electric field.

Optionally, and in accordance with any of the above, the apparatus includes an insulating material surrounding the first conducting wire and located between the first conducting wire and the shield.

Optionally, and in accordance with any of the above, the second conducting wire is located on an external surface of the shield.

Optionally, and in accordance with any of the above, the second conducting wire is located on an internal surface of the shield between the shield and the first conducting wire.

Optionally, and in accordance with any of the above, the ground connection further may include an electroconductive sleeve electrically connected to at least one of the shield and the second conductive wire to provide the connection to ground.

Optionally, and in accordance with any of the above, the second conducting wire may further include an insulating material surrounding the second conducting wire.

Optionally, and in accordance with any of the above, the ground connection further connects the shield or the second wire to ground to provide static protection to the first conducting wire.

Optionally, and in accordance with any of the above, protection of the signals from the electromagnetic interference is provided between first and second locations where the second conducting wire connects to the shield.

According to another aspect of the present invention, an apparatus for protecting signals from electromagnetic interference includes a first conducting wire configured to carry the signals from a first end of the first conducting wire to a second end of the first conducting wire, a shield made of a conducting material surrounding the first conducting wire from the first end of the first conducting wire to the second end of the first conducting wire, an insulating material surrounding the first conducting wire and located between the first conducting wire and the shield, a second conducting wire associated with the shield and an electroconductive sleeve electrically connected to the shield or the second wire, and the second conductive wire configured to connect the second conducting wire to ground at a single location, where the electroconductive sleeve is further configured to connect the shield to ground to provide static protection to the first conducting wire.

Optionally, and in accordance with the above, an electrical circuit created between the second conducting wire, the shield and the electroconductive sleeve generates an electric current responsive to an external electric field in a first direction, the electric current generating an internal electric field in a second direction, where the internal electric field substantially eliminates effects of the external electric field to protect the signals on the first conducting wire from interference by the external electric field.

Optionally, and in accordance with any of the above, the second conducting wire is located on an external surface of the shield.

Optionally, and in accordance with any of the above, the second conducting wire is located on an internal surface of the shield between the shield and the first conducting wire.

Optionally, and in accordance with any of the above, the second conducting wire may further include an insulating material surrounding the second conducting wire.

Optionally, and in accordance with any of the above, protection of the signals from the electromagnetic interference is provided between first and second locations where the second conducting wire connects to the shield.

According to another aspect of the present invention, a method for protecting signals from electromagnetic interference includes carrying the signals from a first end of a first conducting wire to a second end of the first conducting wire over a first conducting wire, surrounding the first conducting wire from the first end of the first conducting wire to the second end of the first conducting wire with a shield made of a conducting material, surrounding the first conducting wire and located between the first conducting wire and the shield with an insulating material, associating a second conductive wire to the shield, electrically connecting an electroconductive sleeve to the shield or and then to ground at a single location, and connecting the shield to ground using the electroconductive sleeve to providing static protection to the first conducting wire.

Optionally, and in accordance with the above, the method may include creating an electrical circuit created by connecting the second conducting wire, the shield and the electroconductive sleeve, generating an electric current using the created electrical circuit responsive to an external electric field in a first direction, generating an internal electric field in a second direction responsive to the electric current and where the internal electric field substantially eliminates effects of the external electric field to protect the signals on the first conducting wire from interference by the external electric field.

Optionally, and in accordance with any of the above, the method may include locating the second conducting wire on an external surface of the shield.

Optionally, and in accordance with any of the above, the method may include locating the second conducting wire on an internal surface of the shield between the shield and the first conducting wire.

Optionally, and in accordance with any of the above, the method may include protecting the signals from the electromagnetic interference between first and second locations where the second conducting wire connects to the shield.

Other technical features may be readily apparent to one skilled in the art from the following figures, descriptions, and claims.

### BRIEF DESCRIPTION OF THE DRAWINGS

For a more complete understanding of this invention and its advantages, reference is now made to the following description taken in conjunction with the accompanying drawings, in which like reference numerals represent like parts:
Figure 1 illustrates the electromagnetic environment (EME) shield operating principle;
Figure 2 illustrates a shielded wire having a single bonding point;
Figure 3 illustrates a schematic diagram of a shielded wire having an integrated bonding wire in accordance with this invention;
Figure 4A illustrates a first embodiment of a shielded wire having an integrated bonding wire in accordance with this invention;
Figure 4B illustrates a second embodiment of a shielded wire having an integrated bonding wire in accordance with this invention;
Figure 4C illustrates a third embodiment of a shielded wire having an integrated bonding wire in accordance with this invention; and
Figure 5 illustrates a flow diagram of the process for providing the shielded wire with an integrated bonding wire in accordance with this invention.

### DETAILED DESCRIPTION

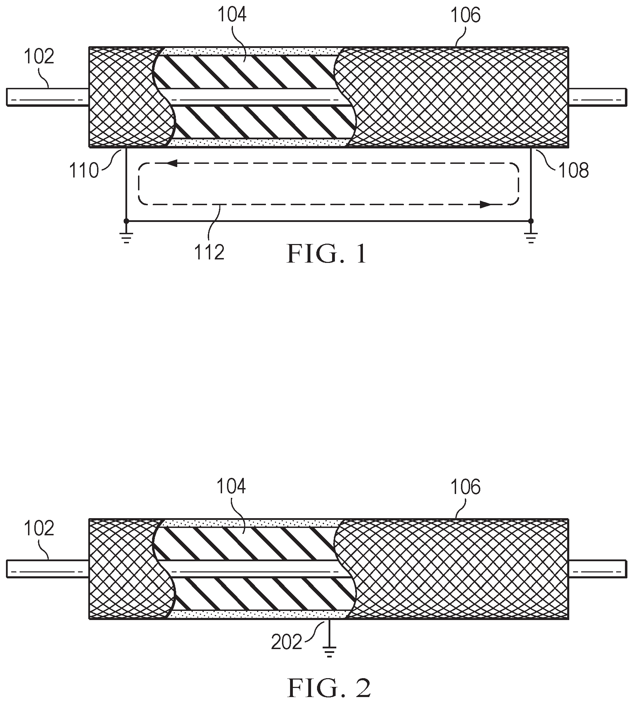

Figures 1 through 5, described below, and the various embodiments used to describe the principles of the present invention are by way of illustration only and should not be construed in any way to limit the scope of this invention. Those skilled in the art will understand that the principles of the present invention may be implemented in any type of suitably arranged device or system.

Figure 1 illustrates a current implementation of a shielded wire using existing shielding techniques. The conducting wire 102 is included within an insulating body 104 through which the conducting wire 102 passes. A shield 106 surrounds the insulating body 104 and provides the electromagnetic shielding. In order to provide the electromagnetic shielding, the shield 106 is grounded at two separate locations 108, 110. The grounding at locations 108, 110 creates a closed circuit through the shield 106. When the circuit is closed (i.e. the shield is grounded at locations 108, 110), an external electric field (not shown) creates the electric current 112 within the shield 106 in a first direction. The electric current 112 creates an internal electric field having an opposite magnitude and direction to the external electric field. The internal electric field and the external electric field counteract each other inside of the space provided by the shield 106 and protects signals passing along the conducting wire 102 from electromagnetic interference. The closed circuit is mandatory for generating the electric current 112, and thus, the protection provided by the shield 106 works only between the bonding locations 108 and 110. Elimination of either of the bonding locations 108, 110 will cut the electric circuit and eliminate the internal electric field. This is more particularly illustrated in the circuit illustrated in Figure 2.

Figure 2 illustrates a further prior art configuration wherein only a single grounding location 202 to the shield 106 is provided. The shield 106 surrounds an insulating body 104 through which the conducting wire 102 passes in a similar manner to that described with respect to Figure 1. Since there is only a single grounding location 202 to the shield 106, no electric current 112 is provided, and thus, no internal electric field is generated. The single grounding location 202 to the shield 106 is used to remove static electricity from the shield 106 which also provides a degree of electromagnetic interference protection to the conducting wire 102.

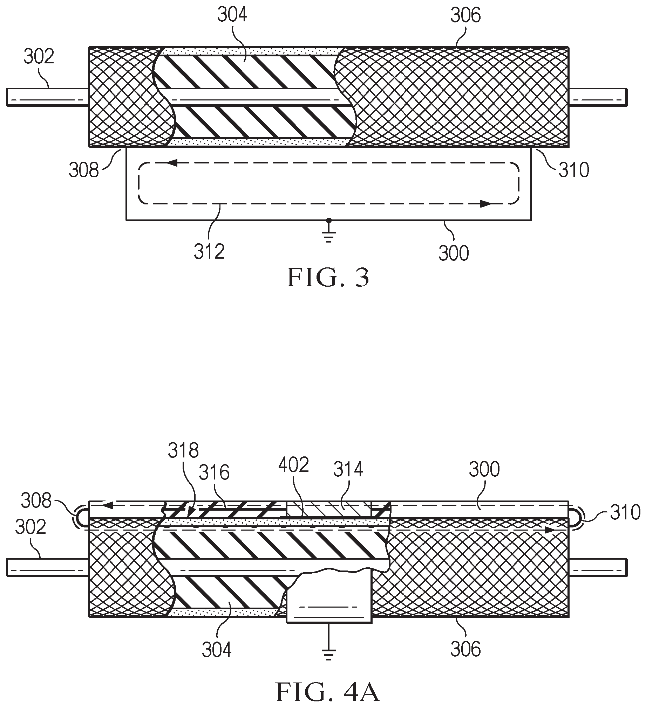

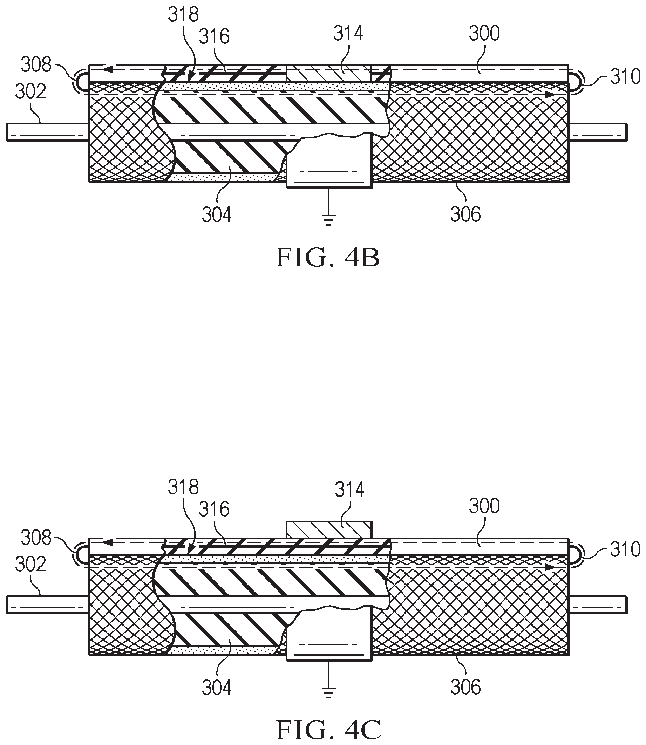

Figure 3 illustrates a schematic diagram of a shielded wire having an integrated bonding wire 300 associated with the shield 306 in accordance with this invention. The implementation of Figure 3 shares the bonding function between the second conducting wire 300 and the shield 306 by introduction of an integrated bonding wire 300 associated with the shield 306 that elongates the shield 306 protection along the conducting wire 302 protected by the shield 306 between points 308 and 310. The implementation of Figure 3 uses a conductive sleeve 314 (Figure 4) for grounding of the integrated bonding wire 300 to the engine case through the conductive sleeve 314. The wire 300 between the two bonding points 308 and 310 may be represented as a grounded external wire attached to the bonding points 308 and 310 on the shield 306.

The integration of the integrated bonding wire 300 to the shielded wire 302 provides an electric current in a "shield-integrated wire shield." This electric current 312 is generated responsive to the external electric field in the manner similar to that described with respect to Figure 1. The electric current 312 generates an internal electric field within the shield 306 that is opposite in direction of the external electric field such that they cancel each other out or significantly reduce the total electric field inside of the body 304, and protect the signals passing through the wire 302. The grounding of static electricity is provided through the shield 306.

Although FIG. 3 illustrates one example of a schematic diagram of a shielded wire having an integrated bonding wire 300 associated with the shield 306, various changes may be made to FIG. 3. For example, various components in FIG. 3 may be combined, further subdivided, replicated, or rearranged according to particular needs. Also, one or more additional components and may be included if needed or desired.

Figure 4A illustrates a first embodiment of the integrated bonding wire 300. The bonding points 308 and 310 of the integrated bonding wire 300 to the shield 306 provides an electro conductive connection between the shield 306 and the integrated bonding wire 300 on both ends of the wire. The integrated bonding wire 300 consists of a conducting wire 316 that is surrounded by insulation 318. The integrated wire 300 is connected to the conductive sleeve 314, isolated from the shield 306 by insulation 402. The conductive sleeve 314 provides a connection of the wire 300 to ground.

Figure 4B illustrates a second embodiment of the integrated bonding wire 300 with the shield 306 in accordance with this invention. The bonding points 308 and 310 of the integrated bonding wire 300 to the shield 306 provides an electro conductive connection between the shield 306 and the integrated bonding wire 300 on both ends of the wire. The integrated bonding wire 300 consists of a conducting wire 316 that is surrounded by insulation 318. The integrated bonding wire 300 is also connected to the conductive sleeve 314. The conductive sleeve 314 provides a connection of the shield 306 and wire 300 to ground.

Figure 4C illustrates a third embodiment wherein the integrated bonding wire 300 is not connected to the conductive sleeve 314 and the conductive sleeve is connected to the shield 306. The conducting wire 316 is isolated from the conductive sleeve 314 by insulation 318. The integrated bonding wire 300 may be located either on the external surface of the shield 306 or the internal surface of the shield 306. The conductive sleeve 314 provides a connection of the shield 306 to ground.

The implementation of Figures 4A-4C will provide electromagnetic interference protection in two separate ways. The electric current 312 implemented by the external electric field causes generation of the internal electric field that cancels out the effects of the external electric field between the two connection points of the integrated bonding wire 300 to the shield 306. In this manner, the signals conducted on the conducting wire 302 are protected from the external electromagnetic fields between these points. Additionally, the connection of the conductive sleeve 314 to ground in the shield 306 provides for static electricity interference protection.

The introduction of the integrated bonding wire 300 elongates the shield protection over the whole length of the wire protected by the shield 306 between the connection points of the integrated bonding wire 300 to the shield 306 and allows the use of a single clamp via conduction sleeve 314 for grounding the shield 306 to the engine case. The implementation may be used on any wire in order to provide electromagnetic and static protection to signals carried by the wire 302.

Although FIGURS 4A-4C illustrates one example the implementation of the integrated bonding wire 300 with the shield 306, various changes may be made to Figures 4A-4C. For example, various components in Figures 4A-4C may be combined, further subdivided, replicated, or rearranged according to particular needs. Also, one or more additional components and may be included if needed or desired.

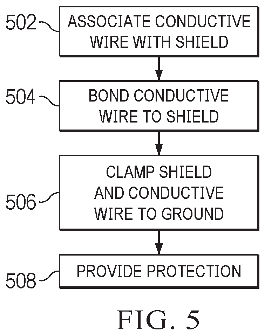

Figure 5 illustrates a flow diagram of the process for providing the shielded wire with an integrated bonding wire 300 in accordance with this invention. A conductive integrated bonding wire 300 is associated at step 502 with the shield 306. The conductive integrated bonding wire 300 is bonded at step 504 at each end of the conductive integrated bonding wire 300 to the shield 306. The shield 306 and the conductive integrated bonding wire 300 are grounded using a conductive sleeve 314 at step 506. The protection is provided at step 508 by the shielded wire with a bonded conductive integrated bonding wire 300 in two separate ways, namely the internal electromagnetic field that counteracts the external electromagnetic field and the static protection provided by the shield 306 connection to ground.

Although FIG. 5 illustrates one example of a flow diagram of the process for providing the shielded wire with an integrated bonding wire 300, various changes may be made to FIG. 5. For example, while shown as a series of steps, various steps in FIG. 5 could overlap, occur in parallel, occur in a different order, occur any number of times, be omitted, or be replaced by other steps.

It may be advantageous to set forth definitions of certain words and phrases used throughout this patent document. The term "couple" and its derivatives refer to any direct or indirect communication between two or more components, whether or not those components are in physical contact with one another. The terms "include" and "comprise," as well as derivatives thereof, mean inclusion without limitation. The term "or" is inclusive, meaning and/or. The phrase "associated with," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, have a relationship to or with, or the like. The phrase "at least one of," when used with a list of items, means that different combinations of one or more of the listed items may be used, and only one item in the list may be needed. For example, "at least one of: A, B, and C" includes any of the following combinations: A, B, C, A and B, A and C, B and C, and A and B and C.

The description in the present invention should not be read as implying that any particular element, step, or function is an essential or critical element that must be included in the claim scope. The scope of patented subject matter is defined only by the allowed claims.

While this invention has described certain embodiments and generally associated methods, alterations and permutations of these embodiments and methods will be apparent to those skilled in the art. Accordingly, the above description of example embodiments does not define or constrain this invention. Other changes, substitutions, and alterations are also possible without departing from the spirit and scope of this invention, as defined by the following claims.

## Claims

1. An apparatus for protecting signals from electromagnetic interference comprising:
a first conducting wire (302) configured to carry the signals from a first end of the first conducting wire (302) to a second end of the first conducting wire (302);
a shield (306) made of a conducting material, the shield (306) surrounding the first conducting wire (302) from the first end of the first conducting wire (302) to the second end of the first conducting wire (302);
a second conducting wire (300) associated with the shield (306); and
a ground connection configured to connect the second conducting wire (300) to ground at a single location.

2. The apparatus of claim 1, wherein an electrical circuit created between the second conducting wire (300), the shield (306) and the ground connection generates an electric current (312) responsive to an external electric field in a first direction, the electric current (312) generating an internal electric field in a second direction, wherein the internal electric field substantially eliminates effects of the external electric field to protect the signals on the first conducting wire (302) from interference by the external electric field.

3. The apparatus of claim 1 or 2, further comprising an insulating material (402) surrounding the first conducting wire (302) and located between the first conducting wire (302) and the shield (306).

4. The apparatus of any preceding claim, wherein the second conducting wire (300) is located on an external surface of the shield (306).

5. The apparatus of any of claims 1 to 3, wherein the second conducting wire (300) is located on an internal surface of the shield (306) between the shield (306) and the first conducting wire (302).

6. The apparatus of any preceding claim, wherein the ground connection further comprises an electroconductive sleeve (314) electrically connected to at least one of the shield (306) and the second conducting wire (300) to provide the connection to ground.

7. The apparatus of any preceding claim, wherein the second conducting wire (300) further comprises an insulating material (318) surrounding the second conducting wire (300).

8. The apparatus of any preceding claim, wherein the ground connection further connects the shield (306) to ground to provide static protection to the first conducting wire (302).

9. The apparatus of any preceding claim, wherein protection of the signals from the electromagnetic interference is provided between first and second locations where the second conducting wire (300) connects to the shield (306).

10. A method for protecting signals from electromagnetic interference comprising:
carrying the signals from a first end of a first conducting wire (302) to a second end of the first conducting wire (302) using the first conducting wire (302);
surrounding the first conducting wire (302) from the first end of the first conducting wire (302) to the second end of the first conducting wire (302) with a shield (306) made of a conducting material;
surrounding the first conducting wire (302) with an insulating material (318) located between the first conducting wire (302) and the shield (306);
providing a second conductive wire (300) associated with the shield (306);
electrically connecting the second conducting wire (300) to ground at a single location using an electroconductive sleeve (314) that is electrically connected to at least one of the shield (306) and the second conductive wire (300); and
connecting the shield (306) to ground using the electroconductive sleeve to provide static protection to the first conducting wire (302).

11. The method of claim 10, further comprising:
creating an electrical circuit by connecting the second conducting wire (300), the shield (306), and the electroconductive sleeve (314);
generating an electric current (312) using the created electrical circuit responsive to an external electric field in a first direction; and
generating an internal electric field in a second direction using the electric current (312),
wherein the internal electric field substantially reduces effects of the external electric field to protect the signals on the first conducting wire (302) from interference by the external electric field.

12. The method of claim 10 or 11, wherein providing the second conductive wire (300) further comprises locating the second conducting wire (300) on an external surface of the shield (306).

13. The method of any of claims 10 or 11, wherein providing the second conductive wire (300) further comprises locating the second conducting wire (300) on an internal surface of the shield (306) between the shield (306) and the first conducting wire (302).

14. The method of any of claims 10 to 13, further comprising protecting the signals from the electromagnetic interference between first and second locations where the second conducting wire (300) connects to the shield (306).
